# FASCICULE DE BREVET EUROPEEN

(11) **EP 3 605 403 B1**
(45) Date de publication et mention de la délivrance du brevet: **28.02.2024**
(21) Numéro de dépôt: 19189149.8
(22) Date de dépôt: 30.07.2019
(51) Int. Cl.: G06N 3/065, G06N 3/049

(54) **NEURONE ARTIFICIEL PROGRAMMABLE ET PROCEDE DE PROGRAMMATION ASSOCIE**
PROGRAMMIERBARES KÜNSTLICHES NEURON UND ENTSPRECHENDES PROGRAMMIERUNGSVERFAHREN
PROGRAMMABLE ARTIFICIAL NEURON AND ASSOCIATED PROGRAMMING METHOD

(30) Priorité: 01.08.2018 FR 1857210
(43) Date de publication de la demande: 05.02.2020
(73) Titulaire: Commissariat à l'Energie Atomique et aux Energies Alternatives, 75015 Paris (FR)
(72) Inventeur: DALGATY, Thomas, 38054 Grenoble Cedex 09 (FR); VIANELLO, Elisa, 38054 Grenoble Cedex 09 (FR)
(74) Mandataire: Cabinet Camus Lebkiri

(56) Documents cités:
- EP-A1- 3 133 535
- CN-A- 102 496 385
- GIACOMO INDIVERI ET AL: "Neuromorphic Silicon Neuron Circuits", FRONTIERS IN NEUROSCIENCE, vol. 5, 1 janvier 2011 (2011-01-01), XP055081025, ISSN: 1662-4548, DOI: 10.3389/fnins.2011.00073
- GROSSI ALESSANDRO ET AL: "Experimental Investigation of 4-kb RRAM Arrays Programming Conditions Suitable for TCAM", IEEE TRANSACTIONS ON VERY LARGE SCALE INTEGRATION (VLSI) SYSTEMS, IEEE SERVICE CENTER, PISCATAWAY, NJ, USA, vol. 26, no. 12, 5 mars 2018 (2018-03-05), pages 2599-2607, XP011702475, ISSN: 1063-8210, DOI: 10.1109/TVLSI.2018.2805470 [extrait le 2018-11-30]
- DALGATY THOMAS ET AL: "Insect-Inspired Elementary Motion Detection Embracing Resistive Memory and Spiking Neural Networks", 7 juillet 2018 (2018-07-07), IMAGE ANALYSIS AND RECOGNITION : 11TH INTERNATIONAL CONFERENCE, ICIAR 2014, VILAMOURA, PORTUGAL, OCTOBER 22-24, 2014, PROCEEDINGS, PART I; IN: LECTURE NOTES IN COMPUTER SCIENCE , ISSN 1611-3349 ; VOL. 8814; [LECTURE NOTES IN COMPUTER SCIENCE; LECT.NO, XP047477999, ISBN: 978-3-642-17318-9 [extrait le 2018-07-07] * abrégé; figures 5,6 * * page 121, ligne 15 - page 122, dernière ligne *
- MIN-WOO KWON ET AL: "Integrate-and-Fire (I&F) Neuron Circuit Using Resistive-Switching Random Access Memory (RRAM)", JOURNAL OF NANOSCIENCE AND NANOTECHNOLOGY, vol. 17, no. 5, 1 mai 2017 (2017-05-01), pages 3038-3041, XP055474211, US ISSN: 1533-4880, DOI: 10.1166/jnn.2017.14025
- SANGHO SHIN ET AL: "Neuronal spike event generation by memristors", CELLULAR NANOSCALE NETWORKS AND THEIR APPLICATIONS (CNNA), 2012 13TH INTERNATIONAL WORKSHOP ON, IEEE, 29 août 2012 (2012-08-29), pages 1-4, XP032253872, DOI: 10.1109/CNNA.2012.6331427 ISBN: 978-1-4673-0287-6
- ZHENG LE ET AL: "Memristor-based synapses and neurons for neuromorphic computing", 2015 IEEE INTERNATIONAL SYMPOSIUM ON CIRCUITS AND SYSTEMS (ISCAS), IEEE, 24 mai 2015 (2015-05-24), pages 1150-1153, XP033183327, DOI: 10.1109/ISCAS.2015.7168842

## Description

### DOMAINE TECHNIQUE DE L'INVENTION

Le domaine technique de l'invention est celui des neurones artificiels et plus particulièrement celui des neurones artificiels programmables.

La présente invention concerne un neurone artificiel et en particulier un neurone artificiel programmable. La présente invention concerne également un procédé de programmation d'un neurone artificiel programmable.

### ARRIERE-PLAN TECHNOLOGIQUE DE L'INVENTION

Dans le domaine des technologies de l'information et de la communication, les réseaux de neurones artificiels font l'objet d'un grand intérêt. Un réseau de neurones artificiels s'inspire du fonctionnement du cerveau humain et comprend une pluralité de neurones artificiels connectés entre eux par le biais de synapses artificielles.

Un neurone artificiel peut être mis en oeuvre par un circuit électrique ayant pour entrée une ou plusieurs connexions synaptiques par lesquelles se propagent des signaux en provenance d'autres neurones artificiels. En fonction des signaux entrants, le neurone artificiel propage ou non une impulsion à sa sortie.

Il existe de nombreux modèles de neurones artificiels. L'un des plus connus est le neurone artificiel de type LIF pour « Leaky Integrate and Fire ». Un neurone artificiel de type LIF intègre une charge en entrée, la dissipe dans le temps et émet une impulsion lorsque la charge intégrée est supérieure à un seuil prédéterminé.

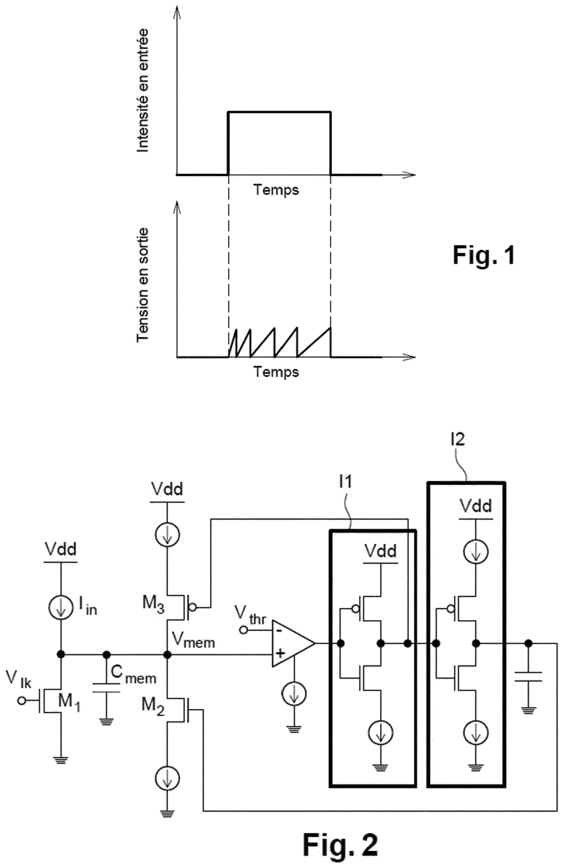

Le comportement d'un neurone artificiel de type LIF est gouverné par plusieurs paramètres comme par exemple une constante de temps définissant la vitesse à laquelle se charge le neurone artificiel, une période réfractaire ou « refractory period » en anglais définissant la période minimale entre deux émissions d'impulsions ou encore un comportement d'adaptation de la fréquence des impulsions ou « spike frequency adaptation behavior » en anglais. Ce dernier paramètre correspond à la diminution de la fréquence d'émission des impulsions quand le neurone artificiel est soumis à un signal échelon, comme illustré à la figure 1.

Classiquement, un neurone artificiel de type LIF est mis en oeuvre par la technologie CMOS qui permet de régler les paramètres du neurone artificiel de type LIF par la polarisation du transistor MOS. Par exemple, la figure 2 illustre un neurone artificiel de type LIF simplifié dans lequel seule la constante de temps est réglée.

A l'arrivée d'un signal d'entrée modélisé par une source de courant lin, un condensateur Cmem se charge à une vitesse dépendant de la résistance drain-source d'un transistor M1 auquel il est connecté en parallèle. Le condensateur Cmem est également connecté en parallèle d'un transistor M2 et d'un transistor M3 et la tension Vmem à ses bornes alimente l'entrée non inverseuse d'un amplificateur opérationnel. La sortie de l'amplificateur opérationnel est reliée à un premier inverseur I1, lui-même relié à un deuxième inverseur I2. Lorsque la tension Vmem aux bornes du condensateur Cmem est supérieure à une tension de seuil Vthr, la sortie de l'amplificateur opérationnel augmente jusqu'à atteindre la tension d'alimentation Vdd. La sortie du premier inverseur I1 diminue alors jusqu'à atteindre une tension nulle et grâce à une rétroaction positive en ouvrant le canal du transistor M3, la tension à l'entrée du neurone artificiel augmente plus rapidement et permet d'accélérer la charge du condensateur Cmem. Simultanément, la sortie du deuxième inverseur I2 augmente jusqu'à atteindre la tension d'alimentation Vdd, constituant le front montant de l'impulsion de sortie. Cependant, lorsque la tension en sortie du deuxième inverseur I2 augmente, elle ouvre le canal du transistor M2 et la tension Vmem aux bornes du condensateur Cmem se décharge rapidement de telle sorte que la tension d'entrée revient à zéro. L'impulsion cesse alors. La décharge du condensateur Cmem est réalisée en polarisant le transistor M1 via la tension Vlk, une tension inférieure à la tension de seuil Vthr, de telle sorte que la résistance drain-source Rds du transistor M1 soit suffisamment élevée pour que le condensateur Cmem se décharge relativement lentement à travers le transistor M1. Ainsi, le circuit de la figure 2 reproduit bien le comportement d'un neurone artificiel de type LIF avec une certaine constante de temps réglée par la capacité du condensateur Cmem et par la résistance drain-source Rds du transistor M1 qui varie avec sa tension de grille Vlk.

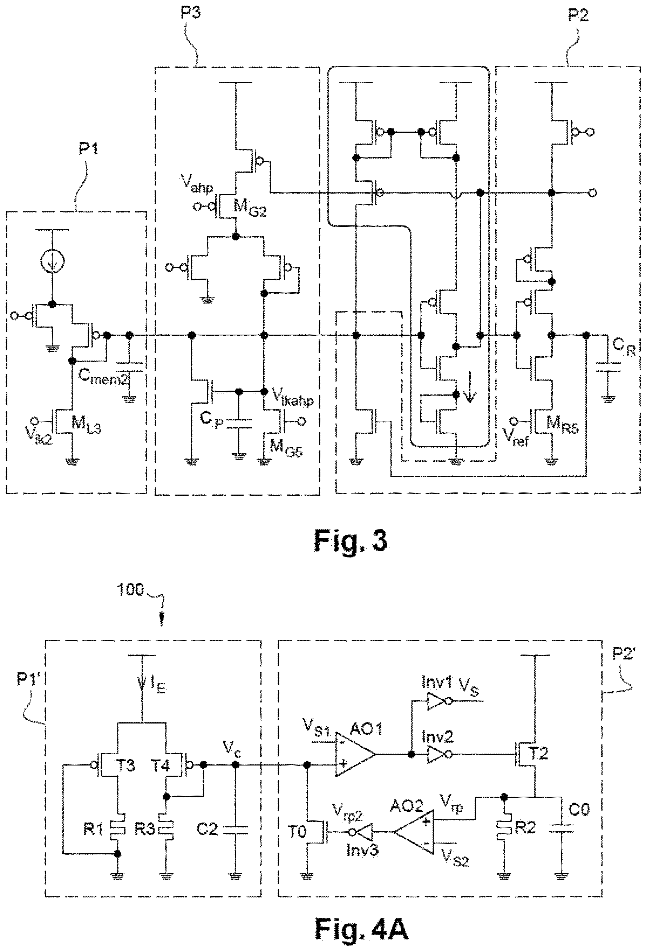

Un neurone artificiel de type LIF mis en oeuvre par de la technologie CMOS et dont le comportement est régulé par plusieurs paramètres est illustré sur la figure 3. La partie P1 du circuit permet de régler une constante de temps par la capacité d'un condensateur Cmem2 et par le résistance drain-source d'un transistor ML3 qui varie avec sa tension de grille Vlk, la partie P2 du circuit permet de régler une période réfractaire par la capacité d'un condensateur CR et la résistance drain-source d'un transistor MR5 qui varie avec sa tension de grille Vref et la partie P3 du circuit permet de régler un comportement d'adaptation de la fréquence des impulsions par la capacité d'un condensateur CP et les résistances drain-source de transistors MG2 et MG5 qui varient respectivement avec leurs tensions de grille Vahp et Vlkahp. Le fonctionnement du circuit de la figure 3 est analogue à celui du circuit décrit précédemment à la figure 2.

Les figures 2 et 3 sont tirées de l'article « Neuromorphic silicon neuron circuits » par G. Indiveri et al. publié dans « Frontiers in Neuroscience », 5, 2011.

Cependant, les valeurs des paramètres des neurones artificiels utilisant la technologie CMOS ne sont pas conservées en cas de mise hors-tension, ce qui entraîne une remise à zéro de la valeur des paramètres. Ceci pose problème du fait que les neurones biologiques stockent la valeur de leurs paramètres en mémoire et par conséquent, un modèle de neurones bio-réaliste ne devrait pas être sujet à la perte d'informations concernant la valeur de ses paramètres.

De plus, les noeuds avancés CMOS ne permettent pas de régler n'importe quelle valeur pour un paramètre, en particulier ils ne permettent pas d'atteindre des valeurs élevées de paramètres quand le courant de fuite devient trop important.

Il existe donc un besoin de mettre en oeuvre un neurone artificiel de type LIF programmable de manière plus efficace, sans perte d'informations et permettant à ses paramètres de prendre n'importe quelle valeur.

GIACOMO INDIVERI ET AL: "Neuromorphic Silicon Neuron Circuits",FRONTIERS IN NEUROSCIENCE, vol. 5, 1 janvier 2011 (2011-01-01), ISSN: 1662-4548, DOI: 10.3389/ fnins.2011.00073 décrit des neurones artificiels basés sur la technologie CMOS.

### RESUME DE L'INVENTION

L'invention offre une solution aux problèmes évoqués précédemment, en permettant de programmer plus efficacement les paramètres d'un neurone artificiel en imposant aucune contrainte sur la valeur de ces paramètres et en limitant la perte d'informations.

L'invention est définie par les revendication indépendantes. Des modes de réalisation préférés sont définis par les revendications dépendantes.

Grâce à l'invention, l'utilisation d'une mémoire résistive non volatile permet de programmer la valeur des paramètres de contrôle du neurone artificiel de manière non volatile, c'est-à-dire sans remise à zéro de la valeur des paramètres en cas de mise hors tension. De plus, les mémoires résistives non volatiles utilisées au sein de noeuds avancés CMOS permettent de régler n'importe quelle valeur de paramètre.

Avantageusement, le neurone artificiel programmable comporte n'importe quel type de mémoire résistive non volatile.

Avantageusement, le comportement du neurone artificiel programmable est régulé par des paramètres régulant le comportement d'un neurone artificiel de type LIF.

Avantageusement, la programmation de chaque paramètre du neurone artificiel programmable est réalisée indépendamment du reste du circuit en plaçant chaque multiplexeur de chaque bloc dans l'état de programmation.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 de l'art antérieur montre un graphe représentant la tension en sortie d'un neurone artificiel de type LIF soumis en entrée à une intensité en échelon, illustrant le comportement d'adaptation de la fréquence des impulsions.
- La figure 2 de l'art antérieur montre un neurone artificiel de type LIF mis en oeuvre avec de la technologie CMOS, dans lequel la valeur d'une constante de temps est réglée par la tension de grille Vlk d'un transistor M1.
- La figure 3 de l'art antérieur montre un neurone artificiel de type LIF mis en oeuvre avec de la technologie CMOS, dans lequel la valeur d'une constante de temps est réglée par la tension de grille Vlk2 d'un transistor ML3, la valeur d'une période réfractaire est réglée par la tension de grille Vref d'un transistor MR5 et la valeur d'un comportement d'adaptation de la fréquence des impulsions est réglée par la tension de grille Vahp d'un transistor MG2 et par la tension de grille Vlkahp d'un transistor MG5.

- La figure 4A montre un exemple de neurone artificiel programmable de type LIF selon un premier aspect de l'invention dont le signal de sortie Vs est contrôlé par une constante de temps et une période réfractaire.
- La figure 4B représente, simultanément en fonction du temps, un graphe de la tension en sortie Vs, un graphe de l'intensité en entrée I_{E}, un graphe de la tension Vc aux bornes d'un condensateur C2 permettant de régler la valeur de la constante de temps et de la tension Vrp aux bornes d'un condensateur C0 permettant de régler la période réfractaire et un graphe de la tension Vrp2 alimentant un transistor T0 dont l'ouverture permet de décharger le condensateur C2 pour le neurone artificiel programmable représenté à la figure 4A.
- La figure 5 montre un bloc permettant de régler la valeur d'un paramètre de contrôle du neurone artificiel programmable selon un premier aspect de l'invention.
- La figure 6 montre un schéma synoptique d'un procédé de programmation selon un deuxième aspect de l'invention.

### DESCRIPTION DETAILLEE

Sauf précision contraire, un même élément apparaissant sur des figures différentes présente une référence unique.

Dans la suite de la description, on emploiera indifféremment les termes « neurone », « neurone artificiel » et « neurone artificiel programmable ».

Les figures 1, 2 et 3 ont déjà été décrites en référence à l'état de la technique.

Nous décrivons un neurone artificiel programmable dont le comportement est gouverné par plusieurs paramètres de contrôle dont les valeurs sont programmables. On entend par « valeurs programmables » des valeurs réglables, c'est-à-dire pouvant être modifiées.

Le neurone artificiel programmable est par exemple un neurone de type LIF pour « Leaky Integrate and Fire ». Le neurone artificiel programmable peut également être un neurone basé sur le modèle Hodkgin-Huxley ou sur le modèle Izkevich.

Un exemple de neurone artificiel programmable 100 de type LIF est illustré à la figure 4A. Le signal de sortie Vs du neurone artificiel 100 illustré à la figure 4A est contrôlé par deux paramètres de contrôle, une constante de temps réglée par une première partie P1' du neurone artificiel 100 et une période réfractaire réglée par une deuxième partie P2' du neurone artificiel 100.

La partie P1' du neurone artificiel 100 comporte une source de courant I_{E} alimentant un noeud se divisant en une première branche comportant un transistor T3 et une mémoire résistive R1 et en une seconde branche comportant un transistor T4 et une mémoire résistive R3, les première et seconde branches étant connectées en parallèle.

Dans la première branche, la mémoire résistive R1 possède une première extrémité reliée à la masse et une seconde extrémité reliée au drain du transistor T3. La grille du transistor T3 est reliée à la première extrémité de la mémoire résistive R1 et la source du transistor T3 est reliée au noeud partagé par les première et seconde branches.

Dans la seconde branche, la mémoire résistive R3 possède une première extrémité reliée à la masse et une seconde extrémité reliée à la source du transistor T4. La grille du transistor T4 est reliée à la seconde extrémité de la mémoire résistive R3 et le drain du transistor T4 est reliée au noeud partagé par les première et seconde branches.

Un condensateur C2 est connecté en parallèle de la mémoire résistive R3. Le condensateur C2 possède une première extrémité reliée à la masse et une seconde extrémité reliée à la grille du transistor T4. La tension aux bornes du condensateur C2 est notée Vc.

La partie P2' du neurone artificiel 100 comporte un premier amplificateur opérationnel AO1 dont l'entrée non inverseuse est reliée à la seconde extrémité du condensateur C2 de la partie P1' et dont l'entrée inverseuse est soumise à une première tension de seuil Vs1. La sortie du premier amplificateur opérationnel AO1 est reliée à un premier inverseur Inv1 dont la sortie génère le signal de sortie Vs et à un deuxième inverseur Inv2, les premier et deuxième inverseurs étant connectés en parallèle.

La partie P2' du neurone artificiel 100 comporte également un condensateur C0 ayant une première extrémité reliée à la masse et une seconde extrémité et un transistor T2 dont la grille est reliée à la sortie du deuxième inverseur Inv2, la source à un générateur de tension, et le drain à la seconde extrémité du condensateur C0.

La partie P2' du neurone artificiel 100 comporte une mémoire résistive R2 connectée en parallèle du condensateur C0 ayant une première extrémité reliée à la masse et une seconde extrémité reliée à la seconde extrémité du condensateur C0. La tension aux bornes du condensateur C0 est notée Vrp.

La partie P2' du neurone artificiel 100 comporte également un second amplificateur opérationnel A02 dont l'entrée non inverseuse est reliée à la seconde extrémité de la mémoire résistive R2q et dont l'entrée inverseuse est alimentée par une seconde tension de seuil Vs2.

La partie P2' du neurone artificiel 100 comporte un transistor T0 et un troisième inverseur Inv3, l'entrée du troisième inverseur Inv3 étant reliée à la sortie du second amplificateur opérationnel AO2 et la sortie du troisième inverseur Inv3 étant reliée à la grille du transistor T0. La tension en sortie du troisième inverseur Inv3 est notée Vrp2.

Le transistor T0 est connecté en parallèle du condensateur C2, sa source étant reliée à la masse et son drain à la seconde extrémité du condensateur C2.

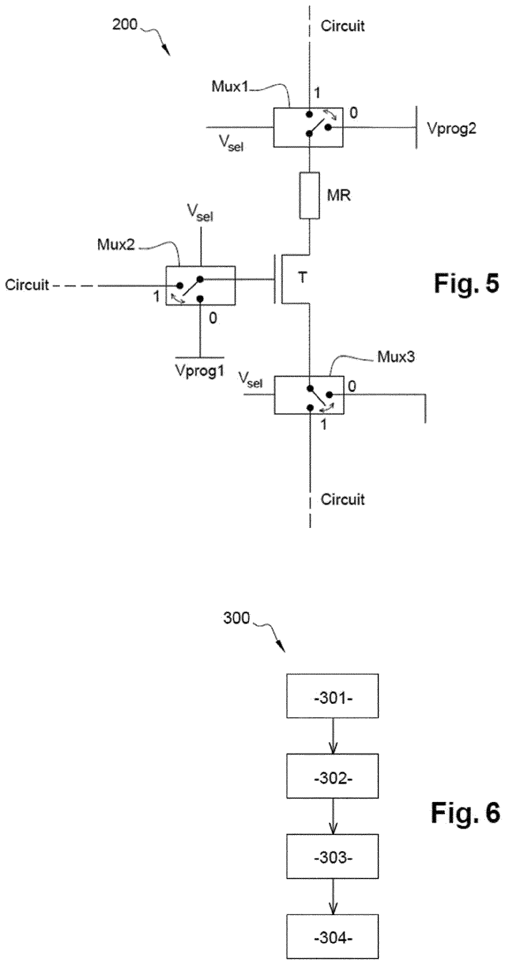

Au sein du neurone artificiel programmable 100, la valeur de chaque paramètre de contrôle est programmable au moyen d'un condensateur et d'au moins un bloc 200 illustré à la figure 5.

Un bloc 200 comporte une mémoire résistive MR possédant une première et une seconde extrémité, un transistor T relié à la première extrémité de la mémoire résistive MR et au moins un multiplexeur Mux.

Le transistor T est par exemple un transistor MOS. La mémoire résistive non volatile MR est par exemple une mémoire OxRAM, CBRAM ou PCRAM.

Une mémoire résistive présente au moins deux états, un état hautement résistif et un état bassement résistif. Le mécanisme d'écriture permettant le stockage de l'information dans la mémoire résistive est appelé SET et consiste à passer de l'état hautement résistif à l'état bassement résistif en appliquant une tension VSET ou un courant adapté à la mémoire résistive. Pour effacer l'information, le matériau actif est commuté de l'état bassement résistif vers l'état hautement résistif en appliquant une tension VRESET ou un courant adapté à la mémoire résistive, le mécanisme d'effacement étant appelé RESET.

Il existe plusieurs types de mémoires résistives :
- les mémoires OxRAM pour « Oxyde RAM » comportant une zone active basée sur un matériau actif à base d'oxyde ;
- les mémoires CBRAM pour « Conductive Bridging RAM » comportant une zone active basée sur un matériau à conduction ionique formant un électrolyte solide à conduction ionique disposé entre une électrode formant une cathode inerte et une électrode comportant une portion de métal ionisable formant une anode ;
- les mémoires PCRAM pour « Phase-Change RAM » comportant un matériau à changement de phase, typiquement un matériau chalcogénure disposé entre une électrode inférieure et une électrode supérieure.

Un multiplexeur Mux présente une entrée de sélection Vsel et deux sorties, une première sortie correspondant à un état de programmation 0 et une seconde sortie à un état de fonctionnement 1, l'entrée de sélection permettant de choisir entre les deux sorties.

Dans l'état de fonctionnement 1, le multiplexeur permet de relier le bloc 200 au reste du circuit constituant le neurone artificiel programmable 100, c'est-à-dire connecté électriquement le bloc 200 au neurone artificiel 100 et dans l'état de programmation 0, il permet de séparer le bloc 200 du reste du circuit constituant le neurone artificiel 100, c'est-à-dire déconnecté électriquement le bloc 200 du neurone artificiel 100. Ainsi, le bloc 200 fait partie du neurone artificiel 100 dans l'état de fonctionnement 1 et est isolé du reste du neurone artificiel 100 dans l'état de programmation 0.

Sur la figure 4A, la constante de temps est réglée par le condensateur C2 et un bloc 200 comportant le transistor T4 et la mémoire résistive R3 et la période réfractaire est réglée par le condensateur C0 et un bloc 200 comportant le transistor T2 et la mémoire résistive R2.

Par souci de simplicité, les multiplexeurs Mux ne sont pas représentés sur la figure 4A. Ainsi, tout se passe comme si les multiplexeurs Mux étaient tous dans l'état de fonctionnement 1.

Sur la figure 5, le bloc 200 comporte trois multiplexeurs Mux1, Mux2 et Mux3.

Le multiplexeur Mux1 est relié à la seconde extrémité de la mémoire résistive MR. Quand il est dans l'état de programmation 0, le multiplexeur Mux1 est relié à une source de tension Vprog2 alors que quand il est dans l'état de fonctionnement 1, le multiplexeur Mux1 est relié au circuit constituant le neurone artificiel 100.

Le multiplexeur Mux2 est relié à la grille du transistor T. Quand il est dans l'état de programmation 0, le multiplexeur Mux2 est relié à une source de tension Vprog1 alors que quand il est dans l'état de fonctionnement 1, le multiplexeur Mux2 est relié au circuit constituant le neurone artificiel 100.

Le multiplexeur Mux3 est relié au drain du transistor T. Quand il est dans l'état de programmation 0, le multiplexeur Mux3 est relié à la masse alors que quand il est dans l'état de fonctionnement 1, le multiplexeur Mux3 est relié au circuit constituant le neurone artificiel 100.

Dans le bloc 200, le transistor T a deux principales fonctions. Une fois la tension VSET ou le courant de SET appliqué à la mémoire résistive MR, le transistor T permet de fixer la valeur de la résistance de la mémoire résistive MR par le biais de la valeur de sa résistance drain-source fixée par la tension de grille appliquée.

Le transistor T permet également de limiter le courant passant dans l'ensemble mémoire résistive MR et transistor T pour protéger la mémoire résistive MR lors des transitions entre son état haute résistance et son état basse résistance. En effet, dans le cas d'une mémoire résistive de type OxRAM par exemple, le passage de l'état haute résistance et à l'état basse résistance est réalisé en appliquant une tension suffisante VSET aux bornes de la mémoire résistive OxRAM. La transition entre l'état haute résistance et l'état basse résistance est très rapide et se traduit par une augmentation brutale du courant lorsque la tension VSET est atteinte. Cette augmentation brutale du courant n'est pas autolimitée, c'est-à-dire que si rien n'est fait pour contrôler cette augmentation, le courant va augmenter jusqu'à des valeurs très élevées susceptibles d'entraîner une augmentation très importante de la température et une destruction de la mémoire résistive MR. Il est donc nécessaire de limiter l'augmentation du courant à une certaine valeur afin d'obtenir un état basse résistance tout en gardant une mémoire résistive intègre. Cette limitation de courant est réalisée par l'ajout du transistor T en série en contrôlant le niveau de limitation à l'aide de sa tension de grille. Plus la tension de grille est importante, plus le courant de saturation sera important. Le transistor T fait ainsi office de moyen de réglage de la limitation de courant de la mémoire résistive MR.

Ainsi, une fois que la valeur de la résistance drain-source du transistor T est fixée par la tension de grille Vprog1, la mémoire résistive MR est soumise à une tension de programmation Vprog2 correspondant à la tension VSET ou au courant de SET ou à la tension VRESET ou au courant de RESET pour régler la valeur de sa résistance.

Dans l'état de fonctionnement 1, la valeur d'un paramètre de contrôle est alors réglée par la valeur de la résistance de la mémoire résistive MR de chaque bloc 200 permettant de régler le paramètre de contrôle en question et par la valeur de la capacité du condensateur connecté en parallèle de la mémoire résistive MR, la valeur de la résistance de la mémoire résistive MR ayant été fixée dans l'état de programmation 0.

Sur la figure 4A, la valeur de la constante de temps est fixée par le condensateur C2 et le bloc 200 comportant le transistor T4 et la mémoire résistive R3.

Le signal d'entrée est modélisé par la source de courant I_{E} se répartissant dans la première branche comportant le transistor T3 et la mémoire résistive R1 et dans la seconde branche comportant le bloc 200 permettant de régler la valeur de la constante de temps. Le rapport des valeurs de résistance des mémoires résistives R1 et R3 permet de régler le partage de courant entre les deux branches.

Le condensateur C2 se charge à une vitesse dépendant de la valeur de la résistance de la mémoire résistive R3.

Lorsque la tension Vc appliquée au condensateur C2 est supérieure à la première tension de seuil Vs1, la sortie du premier amplificateur opérationnel AO1 augmente déclenchant une impulsion Vs à la sortie du premier inverseur Inv1.

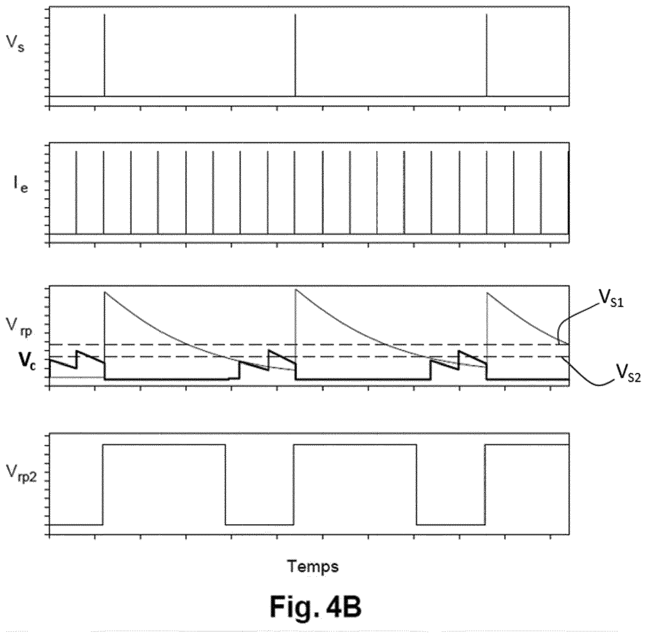

Sur la figure 4B sont représentés simultanément et en fonction du temps, les graphes de la tension de sortie Vs, de l'intensité d'entrée I_{E} et de la tension Vc aux bornes du condensateur C2.

L'intensité en entrée I_{E} est un signal émettant périodiquement une même impulsion.

Initialement, le condensateur C2 est déchargé. A l'arrivée de la première impulsion en entrée, le condensateur C2 se charge instantanément. Entre la première et la deuxième impulsion, le condensateur C2 se décharge dans la mémoire résistive R3 sans revenir à zéro. A la deuxième impulsion, le condensateur se charge à nouveau avant de se décharger entre la deuxième et la troisième impulsion. La tension Vc aux bornes du condensateur C2 lors de la deuxième impulsion est plus élevée que la tension Vc aux bornes du condensateur C2 lors de la première impulsion, autrement dit le condensateur C2 n'a pas le temps de se décharger complètement entre deux impulsions.

A la troisième impulsion, le neurone artificiel programmable 100 émet une impulsion puisque la tension Vc aux bornes du condensateur C2 est supérieure à la première tension de seuil Vs1 ce qui entraîne instantanément la décharge complète du condensateur C2.

Ainsi, la valeur du paramètre de contrôle programmé par la valeur de la capacité du condensateur C2 et par la valeur de la résistance de la mémoire résistive R3 correspond bien à la vitesse à laquelle se charge le neurone artificiel 100 avant d'émettre une impulsion, c'est-à-dire à la constante de temps du neurone artificiel de type LIF.

Sur la figure 4A, la valeur de la période réfractaire est fixée par le condensateur C0 et le bloc 200 comprenant le transistor T2 et la mémoire résistive R2.

Simultanément à la génération de l'impulsion Vs, le canal du transistor M2 à la sortie du deuxième inverseur Inv2 s'ouvre et le condensateur C0 se charge à une vitesse dépendant de la valeur de la résistance de la mémoire résistive R2.

Quand la tension Vrp aux bornes du condensateur C0 est supérieure à la deuxième tension de seuil Vs2, la sortie du second amplificateur opérationnel A02 augmente et la tension Vrp2 en sortie du troisième inverseur Inv3 ouvre le canal du transistor T0. La tension Vc aux bornes du condensateur C2 se décharge alors rapidement de telle sorte que la tension d'entrée revient à zéro. L'impulsion cesse alors.

Une fois l'impulsion Vs terminée, le condensateur C0 se décharge dans la résistance R2 qui conditionne la vitesse de décharge du condensateur C0.

Tant que la tension Vrp aux bornes du condensateur C0 est supérieure à la deuxième tension de seuil Vs2, le canal du transistor T0 est ouvert et le condensateur C2 ne peut pas se charger, limitant ainsi l'émission d'impulsions.

Sur la figure 4B sont également représentés simultanément et en fonction du temps, les graphes de la tension Vrp aux bornes du condensateur C0 et de la tension Vrp2 alimentant la grille du transistor T0.

Simultanément à la première impulsion émise par le neurone artificiel programmable 100, le condensateur C0 se charge et la tension à ses bornes excède la deuxième tension de seuil Vs2. Le canal du transistor T0 s'ouvre alors et le condensateur C2 se décharge instantanément.

Une fois la première impulsion émise par le neurone artificiel programmable 100 terminée, le condensateur C0 se décharge dans la mémoire résistive R2.

Tant que la tension Vrp aux bornes du condensateur C0 ne passe pas en dessous de la deuxième tension de seuil Vs2, le canal du transistor T0 est ouvert et le condensateur C2 ne se charge pas malgré les impulsions en entrée.

Ainsi, jusqu'à la septième impulsion comprise, la tension Vc aux bornes du condensateur C2 reste nulle.

Entre la septième et la huitième impulsion en entrée, la tension Vrp aux bornes du condensateur C0 passe en dessous de la deuxième tension de seuil Vs2 et le canal du transistor T0 se ferme.

A la huitième impulsion, le condensateur C2 se charge alors à nouveau pendant que le condensateur C0 continue de se décharger.

Ainsi, la valeur du paramètre de contrôle programmée par la valeur de la capacité du condensateur C0 et par la valeur de la résistance de la mémoire résistive R2 correspond bien à la période minimale entre deux émissions d'impulsions, c'est-à-dire à la période réfractaire du neurone artificiel de type LIF.

La période réfractaire est visible sur le graphe de la figure 4B illustrant la tension Vrp2 alimentant le transistor T0.

Le circuit de la figure 4A a un fonctionnement similaire à un circuit qui ne comprendrait que les parties P1 et P2 du circuit de la figure 3, en remplaçant le transistor ML3 par la mémoire résistive R3 et le transistor MR5 par la mémoire résistive R2. Ainsi, l'homme du métier cherchant à confectionner un neurone artificiel programmable dont le comportement est également gouverné par un comportement d'adaptation de la fréquence des impulsions ajouterait la partie P3 du circuit de la figure 3 au circuit de la figure 4A en remplaçant les transistors MG2 et MG5 par des mémoires résistives. Deux blocs 200 sont ainsi nécessaires à la programmation du comportement d'adaptation de la fréquence des impulsions.

La figure 6 concerne un procédé de programmation 300 d'un neurone artificiel programmable 100 selon un premier aspect de l'invention.

Une première étape 301 du procédé de programmation 300 consiste à placer chaque multiplexeur Mux de chaque bloc 200 dans un état de programmation 0 par le biais de l'entrée de sélection Vsel.

Une fois que la première étape 301 est réalisée, chaque bloc 200 du neurone artificiel programmable 100 est isolé du reste du circuit, c'est-à-dire déconnecté électriquement du neurone artificiel 100, et la grille du transistor T de chaque bloc 200 est connecté électriquement à une source de tension et la mémoire résistive MR de chaque bloc 200 est connectée électriquement à une source de programmation.

Une deuxième étape 302 du procédé de programmation 300 consiste à fixer la valeur de la résistance drain-source du transistor T de chaque bloc 200 en lui appliquant une tension de programmation Vprog1 avec la source de tension afin de limiter le courant traversant l'ensemble mémoire résistive MR et transistor T.

Une troisième étape 303 du procédé de programmation 300 consiste ensuite à programmer la valeur de la résistance de la mémoire résistive MR de chaque bloc 200 avec la source de programmation. Pour cela, la mémoire résistive MR est soumise à une tension de programmation Vprog2 ou à un courant adapté pour modifier la valeur de sa résistance.

A l'issue de la troisième étape 303, la valeur de la résistance de la mémoire résistive MR est fixée à la valeur souhaitée.

Une quatrième étape 304 du procédé de programmation 300 consiste alors à placer chaque multiplexeur Mux dans un état de fonctionnement 1 par le biais de l'entrée de sélection Vsel.

Une fois que la quatrième étape 304 est réalisée, les blocs 200 du neurone artificiel programmable 100 sont intégrés au neurone artificiel 100, c'est-à-dire connectés électriquement au neurone artificiel 100 et la valeur de la résistance de chaque mémoire résistive MR est fixée à la valeur souhaitée.

Les paramètres de contrôle du neurone artificiel programmable 100 sont alors programmés de manière non volatile.

## Revendications

1. Neurone artificiel programmable (100) émettant un signal de sortie (Vs) contrôlé par au moins un paramètre de contrôle, comportant, pour chaque paramètre de contrôle desdits au moins un paramètre de contrôle, un condensateur et au moins un bloc (200) associé au dit paramètre de contrôle desdits au moins un paramètre de contrôle, ledit neurone étant **caractérisé en ce que** ledit au moins un bloc (200) comprend :
- au moins un multiplexeur (Mux) configuré pour être dans deux états : un état de programmation (0) dudit au moins un bloc (200) et un état de fonctionnement (1) ;
- un transistor (T) ; et
- une mémoire résistive non volatile (MR) connectée en série avec ledit transistor (T), ledit condensateur et ladite mémoire résistive non volatile (MR) étant montés en parallèle ;
ledit au moins un multiplexeur (Mux) étant configuré pour :
∘ lorsqu'il est dans l'état de programmation (0), déconnecter électriquement ledit au moins un bloc (200) du neurone artificiel (100), connecter électriquement la grille du transistor (T) dudit au moins un bloc (200) à une source de tension et connecter électriquement la mémoire résistive (MR) dudit au moins un bloc (200) à une source de programmation, la valeur du paramètre de contrôle étant réglée par la valeur de la résistance de la mémoire résistive et par la capacité du condensateur ;
∘ lorsqu'il est dans l'état de fonctionnement (1), connecter électriquement ledit au moins un bloc (200) au neurone artificiel (100).

2. Neurone artificiel programmable (100) selon la revendication 1, caractérisé en ce le transistor (T) est un transistor MOS.

3. Neurone artificiel programmable (100) selon la revendication 1 ou 2, **caractérisé en ce que** la mémoire résistive non volatile (MR) est une mémoire de type OxRAM, CBRAM ou PCRAM.

4. Neurone artificiel programmable (100) selon l'une quelconque des revendications précédentes, **caractérisé en ce que**, lorsque le paramètre de contrôle desdits au moins un paramètre de contrôle est une constante de temps, le neurone artificiel programmable (100) comporte au moins un bloc (200) et un condensateur.

5. Neurone artificiel programmable (100) selon l'une quelconque des revendications précédentes, **caractérisé en ce que**, lorsque le paramètre de contrôle desdits au moins un paramètre de contrôle est une période réfractaire, le neurone artificiel programmable (100) comporte au moins un bloc (200) et un condensateur.

6. Neurone artificiel programmable (100) selon l'une quelconque des revendications précédentes, **caractérisé en ce que**, lorsque le paramètre de contrôle desdits au moins un paramètre de contrôle est un comportement d'adaptation de la fréquence des impulsions, le neurone artificiel programmable (100) comporte deux au moins un bloc (200) et un condensateur.

7. Procédé de programmation (300) d'un neurone artificiel programmable (100) selon l'une quelconque des revendications précédentes, **caractérisé en ce qu'**il comporte pour chaque bloc desdits au moins un bloc (200), les étapes suivantes :
- Déconnecter électriquement le bloc (200) du neurone artificiel (100), connecter électriquement la grille du transistor (T) du bloc (200) à une source de tension et connecter électriquement la mémoire résistive (MR) du bloc (200) à une source de programmation en plaçant chaque multiplexeur desdits au moins un multiplexeur (Mux) du bloc (200) dans un état de programmation (0), (301) ;
- Appliquer une tension (Vprog1) sur la grille du transistor (T) du bloc (200) avec la source de tension pour fixer la valeur de la résistance drain-source du transistor (T), (302) ;
- Appliquer une tension (Vprog2) ou un courant de programmation avec la source de programmation pour régler la valeur de résistance de la mémoire résistive non volatile (MR) du bloc (200), (303); et
- Connecter électriquement le bloc (200) au neurone artificiel (100) en plaçant chaque multiplexeur desdits au moins un multiplexeur (Mux) dans un état de fonctionnement (1), (304).

## Patentansprüche

1. Programmierbares künstliches Neuron (100), das ein Ausgangssignal (Vs) sendet, das durch mindestens einen Steuerparameter gesteuert wird, das für jeden Steuerparameter der mindestens einen Steuerparameter einen Kondensator und mindestens einen Block (200) umfasst, der dem Steuerparameter der mindestens einen Steuerparameter zugeordnet ist, wobei das Neuron **dadurch gekennzeichnet ist, dass** der mindestens eine Block (200) umfasst:
- mindestens einen Multiplexer (Mux), der so konfiguriert ist, dass er sich in zwei Zuständen befindet, einem Programmierzustand (0) des mindestens einen Blocks (200) und einem Betriebszustand (1);
- einen Transistor (T); und
- einen nichtflüchtigen resistiven Speicher (MR), der mit dem Transistor (T) in Reihe geschaltet ist, wobei der Kondensator und der nichtflüchtige resistive Speicher (MR) parallel geschaltet sind;
wobei der mindestens eine Multiplexer (Mux) konfiguriert ist, um:
∘ wenn er sich im Programmierzustand (0) befindet, den mindestens einen Block (200) von dem künstlichen Neuron (100) elektrisch zu trennen, das Gate des Transistors (T) des mindestens einen Blocks (200) elektrisch mit einer Spannungsquelle zu verbinden und den resistiven Speicher (MR) des mindestens einen Blocks (200) elektrisch mit einer Programmierquelle zu verbinden, wobei der Wert des Steuerparameters durch den Wert des Widerstands des resistiven Speichers und durch die Kapazität des Kondensators eingestellt wird;
∘ wenn er sich im Betriebszustand (1) befindet, den mindestens einen Block (200) elektrisch mit dem künstlichen Neuron (100) zu verbinden.

2. Programmierbares künstliches Neuron (100) nach Anspruch 1, **dadurch gekennzeichnet, dass** der Transistor (T) ein MOS-Transistor ist.

3. Programmierbares künstliches Neuron (100) nach Anspruch 1 oder 2, **dadurch gekennzeichnet, dass** der nichtflüchtige resistive Speicher (MR) ein Speicher vom Typ OxRAM, CBRAM oder PCRAM ist.

4. Programmierbares künstliches Neuron (100) nach einem der vorhergehenden Ansprüche, **dadurch gekennzeichnet, dass**, wenn der Steuerparameter des mindestens einen Steuerparameters eine Zeitkonstante ist, das programmierbare künstliche Neuron (100) mindestens einen Block (200) und einen Kondensator umfasst.

5. Programmierbares künstliches Neuron (100) nach einem der vorhergehenden Ansprüche, **dadurch gekennzeichnet, dass**, wenn der Steuerparameter des mindestens einen Steuerparameters eine Refraktärperiode ist, das programmierbare künstliche Neuron (100) mindestens einen Block (200) und einen Kondensator umfasst.

6. Programmierbares künstliches Neuron (100) nach einem der vorhergehenden Ansprüche, **dadurch gekennzeichnet, dass**, wenn der Steuerparameter des mindestens einen Steuerparameters ein Impulsfrequenzanpassungsverhalten ist, das programmierbare künstliche Neuron (100) mindestens einen Block (200) und einen Kondensator umfasst.

7. Verfahren zur Programmierung (300) eines programmierbaren künstlichen Neurons (100) nach einem der vorhergehenden Ansprüche, **dadurch gekennzeichnet, dass** es für jeden Block des mindestens einen Blocks (200) die folgenden Schritte umfasst:
- den Block (200) elektrisch vom künstlichen Neuron (100) trennen, das Gate des Transistors (T) des Blocks (200) elektrisch mit einer Spannungsquelle verbinden und den resistiven Speicher (MR) des Blocks (200) elektrisch mit einer Programmierquelle verbinden, indem jeder Multiplexer der mindestens einen Multiplexer (Mux) des Blocks (200) in einen Programmierzustand (0), (301) gebracht wird;
- das Anlegen einer Spannung (Vprog1) an das Gate des Transistors (T) des Blocks (200) mit der Spannungsquelle, um den Wert des Drain-Source-Widerstands des Transistors (T), (302) festzulegen;
- das Anlegen einer Spannung (Vprog2) oder eines Programmierstroms mit der Programmierquelle, um den Widerstandswert des nichtflüchtigen resistiven Speichers (MR) des Blocks (200), (303) einzustellen und
- das elektrische Verbinden des Blocks (200) mit dem künstlichen Neuron (100), indem jeder Multiplexer der mindestens einen Multiplexer (Mux) in einen Betriebszustand (1), (304) versetzt wird.

## Claims

1. Programmable artificial neuron (100) emitting an output signal (Vs) controlled by at least one control parameter, comprising, for each control parameter among said at least one control parameter, a capacitor and at least one block (200) associated with said control parameter among said at least one control parameter, said neuron being **characterized in that** said at least one block (200) includes:
- at least one multiplexer (Mux) configured to be in two states: a programming state (0) of said at least one block (200) and an operating state (1);
- a transistor (T); and
- a non-volatile resistive random access memory (MR) connected in series with said transistor (T), said capacitor and said non-volatile resistive random access memory (MR) being mounted in parallel;
said at least one multiplexer (Mux) being configured to:
∘ when it is in the programming state (0), electrically disconnect said at least one block (200) from the artificial neuron (100), electrically connect the gate of the transistor (T) of said at least one block (200) to a voltage source and electrically connect the resistive random access memory (MR) of said at least one block (200) to a programming source, the value of the control parameter being adjusted by the resistance value of the resistive random access memory and by the capacitance value of the capacitor;
∘ when it is in the operating state (1), electrically connect said at least one block (200) to the artificial neuron (100).

2. Programmable artificial neuron (100) according to claim 1, **characterised in that** the transistor (T) is a MOS transistor.

3. Programmable artificial neuron (100) according to claim 1 or 2, **characterised in that** the non-volatile resistive random access memory (MR) is an OxRAM, CBRAM or PCRAM type memory.

4. Programmable artificial neuron (100) according to any of the preceding claims, **characterised in that**, when the control parameter among said at least one control parameter is a time constant, the programmable artificial neuron (100) comprises at least one block (200) and a capacitor.

5. Programmable artificial neuron (100) according to any of the preceding claims, **characterised in that**, when the control parameter among said at least one control parameter is a refractory period, the programmable artificial neuron (100) comprises at least one block (200) and a capacitor.

6. Programmable artificial neuron (100) according to any of the preceding claims, **characterised in that**, when the control parameter among said at least one control parameter is a spike frequency adaptation behaviour, the programmable artificial neuron (100) comprises two blocks (200) and a capacitor.

7. Method for programming (300) a programmable artificial neuron (100) according to any of the preceding claims, **characterised in that** it comprises for each block (200) among said at least one block, the following steps:
- Electrically disconnecting the block (200) from the artificial neuron (100), electrically connecting the gate of the transistor (T) of the block (200) to a voltage source and electrically connecting the resistive random access memory (MR) of the block (200) to a programming source by placing each multiplexer of said at least one multiplexer (Mux) of the block (200) in a programming state (0), (301);
- Applying a voltage (Vprogl) to the gate of the transistor (T) of the block (200) with the voltage source to set the value of the drain-source resistance of the transistor (T), (302);
- Applying a programming voltage (Vprog2) or a current with the programming source to adjust the resistance value of the non-volatile resistive random access memory (MR) of the block (200), (303); and;
- Electrically connecting the block (200) to the artificial neuron (100) by placing each multiplexer (Mux) of said at least one multiplexer in an operating state (1), (304).
